# EUROPÄISCHE PATENTSCHRIFT

(11) **EP 3 390 698 B1**
(45) Veröffentlichungstag und Bekanntmachung des Hinweises auf die Patenterteilung: **03.02.2021**
(21) Anmeldenummer: 16809795.4
(22) Anmeldetag: 09.12.2016
(51) Int. Cl.: C23C 16/44, C30B 29/06, H01L 21/02, C23C 16/02, C30B 25/18

(54) **VERFAHREN ZUM EPITAKTISCHEN BESCHICHTEN VON HALBLEITERSCHEIBEN**
METHOD FOR EPITAXIAL COATING OF SEMICONDUCTOR WAFERS
PROCÉDÉ POUR EFFECTUER LE REVÊTEMENT ÉPITAXIQUE DE TRANCHES DE SEMI-CONDUCTEUR

(30) Priorität: 17.12.2015 DE 102015225663
(43) Veröffentlichungstag der Anmeldung: 24.10.2018
(73) Patentinhaber: Siltronic AG, 81737 München (DE)
(72) Erfinder: HAGER, Christian, 84556 Kastl (DE); MAY, Katharina, 84489 Burghausen (DE); WEBER, Christof, 84489 Burghausen (DE)
(74) Vertreter: Killinger, Andreas
(86) Internationale Anmeldenummer: PCT/EP2016/080494
(87) Internationale Veröffentlichungsnummer: WO 2017/102597

(56) Entgegenhaltungen:
- WO-A1-2016/155915
- DE-A1-102005 045 338
- DE-A1-102005 045 339
- JP-A- 2009 278 035

## Beschreibung

Die vorliegende Erfindung betrifft ein Verfahren zum Beschichten von Halbleiterscheiben mit einer epitaktisch abgeschiedenen Schicht in einem Epitaxie-Reaktor sowie eine Halbleiterscheibe.

### Stand der Technik

Epitaktisch beschichtete Halbleiterscheiben, insbesondere Siliziumscheiben, eignen sich bspw. für die Verwendung in der Halbleiterindustrie, insbesondere zur Fabrikation von hochintegrierten elektronischen Bauelementen wie bspw. Mikroprozessoren oder Speicherchips. Für die moderne Mikroelektronik werden Ausgangsmaterialien, sog. Substrate, mit hohen Anforderungen an globale und lokale Ebenheit, Randgeometrie, Dickenverteilung, Einseiten-bezogene lokale Ebenheit, sog. Nanotopologie, und Defektfreiheit benötigt.

Zum epitaktischen Beschichten von Halbleiterscheiben in einem Epitaxie-Reaktor wird ein Abscheidegas durch den Epitaxie-Reaktor geleitet, wodurch sich auf einer Oberfläche der Halbleiterscheiben epitaktisch Material abscheidet. Außer auf den Halbleiterscheiben scheidet sich das Material jedoch auch im Inneren des Epitaxie-Reaktors ab. Daher ist es üblicherweise notwendig, solche Rückstände von Oberflächen im Epitaxie-Reaktor von Zeit zu Zeit zu entfernen, die sich während des Abscheidens auf diesen Oberflächen unkontrolliert abgelagert haben.

Aus der DE 10 2005 045 339 A1 ist bspw. ein Verfahren zum epitaktischen Beschichten von Halbleiterscheiben bekannt, bei dem nach einer bestimmten Anzahl an Beschichtungsvorgängen in einem Reinigungsvorgang, bei dem ein Ätzgas durch den Epitaxie-Reaktor geleitet wird, der Epitaxie-Reaktor von unerwünscht abgeschiedenem Material zumindest teilweise befreit wird.

Gemäß der Lehre von DE 10 2005 045 339 A1 werden vor einem Beschichtungsvorgang in einem ersten Schritt eine Vorbehandlung mit Wasserstoff und in einem zweiten Schritt ein Ätzvorgang mit Wasserstoff und Chlorwasserstoff durchgeführt. In diesem zweiten Schritt ist der Gasfluss des Wasserstoffs gegenüber dem ersten Schritt deutlich reduziert, bspw. auf unter 10 slm (Standard-Liter pro Minute), wodurch die Konzentration des Chlorwasserstoffs relativ zum Wasserstoff höher wird. Dies führt zu einem verstärkten Abtrag von Material am Rand der Halbleiterscheibe, wodurch wiederum eine verbesserte globale Ebenheit der epitaktisch beschichteten Scheibe erreicht wird.

Allerdings treten beim Beschichten von Halbleiterscheiben trotzdem Variationen der Geometrie zwischen den einzelnen Halbleiterscheiben auf. Insbesondere im Randbereich der Beschichtung gibt es Abweichungen, was der Qualität der beschichteten Halbleiterscheiben abträglich ist. Bspw. kann der Randbereich daher nicht oder nur für Anwendungen mit geringeren Qualitätsanforderungen verwendet werden.

Weiterhin beschreibt DE 10 2005 045448 A1 eine epitaktisch beschichtete Halbleiterscheibe bei welcher durch Einstellung der Behandlungsdauer der Ätzbehandlung verbesserte Randgeometrien und sehr niedrige Edge-Roll-Off Parameter eingestellt werden. Es wird eine Maßnahme beschrieben, um die Abtragsrate auf einen bestimmten Bereich zu begrenzen. Diese Maßnahme besteht aus der Veränderung der chemischen Zusammensetzung des Ätzmediums, der Konzentration von HCl in Wasserstoff. Diese Maßnahme zeigt eine geringe Verbesserung hinsichtlich der lokalen Geometrie am Rand des Wafers.

Die Erfinder haben aber erkannt, dass die Verwendung dieser Maßnahme alleine nicht ausreichend ist, um die Randgeometrie der Wafer in dem gewünschten Maße zu verbessern.

Es ist daher wünschenswert, eine Möglichkeit anzugeben, Variationen in der Geometrie von epitaktisch beschichteten Halbleiterscheiben zu vermeiden oder zumindest zu verringern.

### Offenbarung der Erfindung

Erfindungsgemäß werden ein Verfahren zum epitaktischen Beschichten von Halbleiterscheiben und eine Halbleiterscheibe mit den Merkmalen der unabhängigen Patentansprüche vorgeschlagen. Vorteilhafte Ausgestaltungen sind Gegenstand der Unteransprüche sowie der nachfolgenden Beschreibung.

Unter einer Halbleiterscheibe wird im Rahmen dieser Erfindung eine Scheibe aus Halbleitermaterial wie beispielsweise Elementhalbleiter (Silicium, Germanium), Verbindungshalbleiter (beispielsweise Aluminium oder Gallium) oder deren Verbindungen (beispielsweise Si₁₋ₓGeₓ, 0 < x < 1; AlGaAs, AlGaInP usw.) verstanden, umfassend eine Vorderseite und eine Rückseite sowie eine umlaufende Kante. Die Kante besteht in der Regel aus zwei durch vorangegangene Schleif- und Ätzprozesse abgeflachte Flächen, den sog. Facetten, und einer umlaufenden, senkrecht zur Oberfläche der Scheibe stehenden Fläche, den sog. Apex oder Blunt. Die Vorderseite der Scheibe aus Halbleitermaterial ist definitionsgemäß diejenige Seite, auf der in nachfolgenden Kundenprozessen die gewünschten Mikrostrukturen aufgebracht werden.

Der Randbereich einer Halbleiterscheibe ist eine ringförmige Fläche auf der Scheibenoberfläche, dessen äußerer Rand mit dem Beginn der Kante übereinstimmt und dessen Dicke im Vergleich zum Durchmesser der Scheibe sehr gering ist.

Unter dem Randausschluss wird eine definierte Entfernung gemessen vom Apex zur Mitte der Scheibe hin verstanden. Der Randausschluss ist in der Regel unabhängig vom Durchmesser der Halbleiterscheibe. Beträgt der Randausschluss beispielsweise 2 mm, erfasst der Randausschluss auch einen Teil des Randbereiches, der allerdings geringer als 2 mm ist, da von den 2 mm noch der Bereich der Facette abgezogen werden muss.

### Vorteile der Erfindung

Ein erfindungsgemäßes Verfahren ist zum epitaktischen Beschichten von Halbleiterscheiben, insbesondere Siliziumscheiben, bevorzugt Siliciumscheiben mit einer [1 0 0] -Orientierung, in einem Epitaxie-Reaktor geeignet. Die epitaktische Beschichtung von Halbleiterscheiben umfasst dabei vereinfacht beschrieben die folgenden Schritte: 1) Auflegen von mindestens einer Halbleiterscheibe auf den mindestens einen sich in einem Epitaxie-Reaktor befindlichen Suszeptor; 2) Erwärmen des Reaktorraumes auf die gewünschte Temperatur (Rampen); 3) Spülen der Reaktorkammer mit Wasserstoff (H2-bake); 4) Einleiten eines Wasserstoff-Chlorwasserstoff-Gemisches in die Reaktorkammer (Ätze, HCl-bake); 5) Epitaktische Beschichtung der mindestens einen Halbleiterscheibe; 6) Abkühlen der Reaktorkammer und Entnahme der mindestens einen Halbleiterscheibe.

Das Spülen der Reaktorkammer mit Wasserstoff, der sog. H2-bake, dient der Entfernung der nativen Oxid-Schicht, die oftmals als Schutzschicht auf der Halbleiterscheibe vorhanden ist. Mit dem anschließenden Einleiten eines Wasserstoff-Chlorwasserstoff-Gemisches in die Reaktorkammer (Ätze, HCl-bake, nachfolgend als Ätzvorgang bezeichnet, wird die Oberfläche der mindestens einen sich in der Reaktorkammer befindlichen Halbleiterscheibe durch das Ätzen für die epitaktische Beschichtung vorbereitet.

Jeweils nach einer vorgebbaren Anzahl an Beschichtungsvorgängen wird ein Reinigungsvorgang (Kammerätze, chamber etching) durchgeführt, bei dem ein zweites Ätzgas, vorzugsweise ebenfalls Chlorwasserstoff, durch den Epitaxie-Reaktor geleitet wird. Vorzugsweise kann anschließend auch noch ein zweites Abscheidegas durch den Epitaxie-Reaktor geleitet werden (Kammerbeschichtung, Coating).

Als Abscheidegas, sowohl für die epitaktische Beschichtung der mindestens einen Halbleiterscheibe als auch für die an den Reinigungsvorgang sich optional anschließende Kammerbeschichtung kann bspw. Trichlorsilan verwendet werden.

Erfindungsgemäß wird nun für zwei oder mehr dem jeweiligen Beschichtungsvorgang vorausgehende Ätzvorgänge wenigstens eine den Ätzvorgang beeinflussende Größe individuell auf den betreffenden Ätzvorgang eingestellt.

Hierbei wurde erkannt, dass sich die Form der Halbleiterscheibe, also die Oberflächentopologie, die sich durch den Ätzvorgang ergibt, merklich durch eine gezielte Einstellung der Parameter des Ätzvorgangs, d.h. den Ätzvorgang beeinflussende Größen, beeinflussen lässt. Durch die vorgeschlagene Einstellung wenigstens einer solchen Größe kann verschiedenen Effekten entgegengewirkt werden, die einen erheblichen Einfluss auf die Form der Halbleiterscheibe haben. Zum einen kann durch eine solche gezielte Einstellung unterschiedlichen Formen, die die Halbleiterscheiben vor dem Ätzvorgang haben, Rechnung getragen werden. Zum anderen kann auch den sich verändernden Bedingungen der aufeinanderfolgenden Ätzvorgänge, die bspw. durch Abscheiden von Material im Epitaxie-Reaktor bei den dazwischenliegenden Beschichtungsvorgängen hervorgerufen werden, Rechnung getragen werden.

Durch die Erfindung kann auf diese Weise unter anderem einer sog. Vierfach-Symmetrie der (100) Oberflächentopologie bzw. Waferdicke entgegengewirkt werden, die sich insbesondere durch anisotropes Aufwachsen bei der Beschichtung von Halbleiterscheiben mit einer [1 0 0] Orientierung im Randbereich ergibt. Einkristallines Silizium wird durch ein kubisches System beschrieben. Im kubischen System ergeben sich 3 Rotationssymmetrien; einen 4-fach mit Blick auf die (100) Ebene, eine 2-fach mit Blick auf die (110) Ebene und eine 3-fach Symmetrie mit Blick auf die (111) Ebene. Durch eine Drehung der (100) Ebene um 90°, also ein Viertel einer kompletten Drehung, um die [100] Achse ergibt sich wieder die gleiche Kristallstruktur; entsprechend ergeben sich 2- und 3-fach Symmetrie für [110] und [111] Orientierung auf weiche die Erfindung ebenfalls anwendbar ist. In eckigen Klammern sind die Miller Indizes für Richtungen angegeben.

Bei der epitaktischen Abscheidung auf eine Oberfläche mit Vierfach-Symmetrie werden bei den 90° Winkeln in Richtung und (kurz 90°-Richtung) Erhöhungen erzeugt, welchen durch die gezielte Einstellung der wenigstens einen Größe beim Ätzvorgang entgegengewirkt werden kann. Für eine detailliertere Erläuterung dieser Vierfach-Symmetrie sei an dieser Stelle auf die Figurenbeschreibung verwiesen.

Durch die Berücksichtigung dieser Effekte können Halbleiterscheiben erzeugt werden, die deutlich bessere Werte für SEMI Spezifikationsparameter wie den ZDD (SEMI-M67), SFQR (SEMI-M1) und ESFQR (SEMI-M67) bzw. ROA (SEMI-M77) aufweisen. Insbesondere können diese verbesserten Werte reproduzierbar bei vielen Beschichtungsvorgängen erreicht werden. In Klammern sind die jeweiligen SEMI Normen angegeben.

Insbesondere lassen sich mit dem vorgeschlagenen Verfahren Halbleiterscheiben mit einem ESFQR-Wert von weniger als 9 nm bei einem Randausschluss von wenigstens 2 mm und wenigstens 50 Sektoren mit jeweils einer Länge von höchstens 40 mm erreichen, was bei herkömmlichen Verfahren nicht erreicht wurde. Für eine detaillierte Erläuterung des ESFQR-Wertes sei an dieser Stelle auf die Figurenbeschreibung verwiesen.

Der Erfinder hat erkannt, dass man die Oberflächengeometrie von epitaktisch beschichteten Halbleiterscheiben gezielt durch Verwendung erhöhter HCI-Flüsse beeinflussen kann. Erfindungsgemäß kann durch den erhöhten HCl-Fluss insbesondere in Verbindung mit einer bestimmten Ätztemperatur sowie einem definierten Wasserstoffgasfluss und einer entsprechenden Dauer des HCl-Bakes, der Ätzabtrag am Rand der Scheibe im Vergleich zur inneren Scheibenfläche gezielt verringert werden.

Erfinsdungsgemäß wird nach einem oder mehreren epitaktischen Beschichtungsvorgängen die wenigstens eine den jeweils vorgelagerten Ätzvorgang beeinflussende Größe gegenüber einem vorausgehenden Ätzvorgang verändert. Auf diese Weise kann den sich verändernden Bedingungen der aufeinanderfolgenden Ätzvorgänge, die bspw. durch Abscheiden von Material im Epitaxie-Reaktor bei den dazwischenliegenden Beschichtungsvorgängen hervorgerufen werden, Rechnung getragen werden.

Insbesondere wird dabei mit jedem Beschichtungsvorgang Material, bspw. Silizium, in der Nähe der Halbleiterscheibe bzw. eines Suszeptors, auf dem die Halbleiterscheibe angeordnet ist, abgeschieden. Dies führt zum einen zu veränderten Strömungsverhältnissen im Epitaxie-Reaktor beim Durchleiten von Gas. Zum anderen verändert sich durch Materialablagerungen auf dem Suszeptor der Temperaturübergang zwischen Suszeptor und der aufliegenden Halbleiterscheibe, wodurch es zu einem unerwünschten Randabfall bei der epitaktisch abgeschiedenen Schicht kommen kann, der die Parameter ZDD, SFQR, ESFQR, ROA beeinflusst. Durch eine Anpassung wenigstens einer Größe, die den dem Beschichtungsvorgang vorgelagerten Ätzvorgang beeinflusst, kann dem entgegengewirkt werden. Besonders bevorzugt ist dabei, wenn die entsprechende Größe bzw. die entsprechenden Größen mit jedem Ätzvorgang geändert bzw. angepasst werden, da damit der bestmögliche Nutzen erreicht wird. Je nach Situation kann es jedoch auch zweckmäßig sein, bspw. nur bei jedem zweiten oder jedem dritten vorgelagerten Ätzvorgang die Größe(n) zu verändern.

Vorteilhafterweise wird die wenigstens eine den Ätzvorgang beeinflussende Größe unter Berücksichtigung von geometrischen Abmessungen der nächsten zu beschichtenden Halbleiterscheibe individuell auf den betreffenden Ätzvorgang eingestellt. Damit kann den unterschiedlichen Formen, die die Halbleiterscheiben vor dem Ätzvorgang haben, Rechnung getragen werden. So lassen sich bspw. durch gezielte Einstellung der Gasflüsse und/oder einer Dauer des Ätzvorgangs unterschiedlich starke Abtragungen an unterschiedlichen Positionen der Oberfläche der Halbleiterscheibe erreichen. Je genauer die Form der Halbleiterscheibe bekannt ist, bspw. durch eine geeignete Vermessung vor dem eigentlichen Beschichtungsvorgang, desto gezielter kann die Größe bzw. können die Größen, die den Ätzvorgang beeinflussen, eingestellt bzw. angepasst werden. Zweckmäßigerweise umfasst die wenigstens eine den dem Beschichtungsvorgang vorgelagerten Ätzvorgang beeinflussende Größe einen Gasfluss des ersten Ätzgases, einen Gasfluss des Trägergases, eine Temperatur im Epitaxie-Reaktor während des Ätzvorgangs, eine Dauer des Ätzvorgangs und/oder eine Rotationsgeschwindigkeit der Halbleiterscheibe. All die genannten Größen beeinflussen den Ätzvorgang. Erfindungsgemäß umfasst die wenigstens eine den Ätzvorgang beeinflussende Größe eine Temperatur im Epitaxier-Reaktor während des Ätzvorgangs.

So kann bspw. ein höherer Gasfluss des Ätzgases einen stärkeren Abtrag in der Mitte der Halbleiterscheibe gegenüber dem Rand bewirken. Mit dem Gasfluss des Trägergases lässt sich bspw. die Konzentration des Ätzgases beeinflussen, was ebenfalls zu einem veränderten Abtrag führen kann. Bei geringerer Temperatur reagiert das Ätzgas weniger stark mit der Halbleiterscheibe, was zu einem geringeren Abtrag führt. Mit längerer Dauer des Ätzvorgangs wird sowohl mehr Material von der Halbleiterscheibe als auch auf dem Suszeptor abgeschiedenes Material abgetragen. Mit veränderter Rotationsgeschwindigkeit kann die Dauer, die das Ätzgas auf die Halbleiterscheibe einwirkt, verändert werden. Es versteht sich, dass nicht notwendigerweise alle diese Größen für einen Ätzvorgang verändert werden müssen. Oftmals ist die Änderung nur einer oder zwei dieser Größen bereits ausreichend, um die für die epitaktische Abscheidung gewünschte Oberflächengeometrie, beispielsweise eine möglichst ebene Oberfläche, der Halbleiterscheibe zu erhalten.

Erfindungsgemäß wird die Temperatur im Epitaxie-Reaktor gegenüber einem vorausgehenden Ätzvorgang erniedrigt und optional die Dauer des Ätzvorgangs gegenüber einem vorausgehenden Ätzvorgang erhöht.

Im erfindungsgemäßen Verfahren hat die Temperatur während des Ätzvorganges einen entscheidenden Einfluss auf den Ätzabtrag am Rand. Durch die Erniedrigung der Temperatur im Epitaxie-Reaktor im Vergleich zu einem vorausgegangenen Ätzvorgang verringert sich auch der Ätzabtrag im Randbereich der auf dem Suszeptor aufliegenden Halbleiterscheibe im Vergleich zum Ätzabtrag im Randbereich einer Halbleiterscheibe aus einem vorausgegangenen Ätzvorgang.

Die Erhöhung der Ätzdauer mit jedem weiteren Ätzvorgang kann beispielsweise jeweils 1 bis 5 Sekunden betragen. Auf diese Weise kann besonders effektiv den sich verändernden Bedingungen der aufeinanderfolgenden Ätzvorgänge Rechnung getragen werden, da in der Regel das unerwünscht abgeschiedene Material neben der Halbleiterscheibe mit jedem Beschichtungsvorgang mehr wird, was zu einem stärkeren Randabfall bei der Beschichtung führt. Je länger der Ätzvorgang dauert, desto mehr an Material kann dann bei geeigneter Einstellung der Gasflüsse von der Oberfläche der Halbleiterscheibe, mit Ausnahme des Randbereiches, abgetragen werden.

Durch die Erniedrigung der Temperatur im Epitaxie-Reaktor und/oder der Erhöhung der Dauer des Ätzvorgangs, jeweils bezogen auf einem vorausgehenden Ätzvorgang, kann kompensiert werden, dass bei unerwünschtem Material im Bereich um die Halbleiterscheibe sich am Rand der Halbleiterscheibe beim Beschichtungsvorgang weniger Material abscheidet. Letzteres liegt im veränderten Strömungsverhalten des durch den Epitaxie-Reaktor strömenden Gases begründet.

Das erfindungsgemäße Verfahren ermöglicht das systematische Kompensieren des zunehmenden Randabfalls bei der Halbleiterscheibe nach der Kammerätze im Verlauf eines Ätzzyklus. Ein Ätzzyklus umfasst die Kammerätze und eine definierte Anzahl an epitakischen Abscheidungen. Die Anzahl der Abscheidungen innerhalb eines Ätzzyklus bzw. bis zur nächsten Kammerätze wird durch die in Summe epitaktisch abgeschiedene Gesamtschichtdicke D bestimmt. Bei jedem epitaktischen Abscheideprozess wird eine Epi-Schicht mit einer definierten Dicke d auf der Halbleiterscheibe abgeschieden. Nach einer bestimmten Anzahl von Abscheideprozessen entspricht die Summe der einzelnen Schichtdicken d der Gesamtschichtdicke D. Damit ist der Ätzzyklus beendet und ein neuer Ätzzyklus startet mit einer weiteren Kammerätze. Beträgt beispielsweise die für einen Ätzzyklus festgelegte Gesamtschichtdicke D = 60 µm und wird pro epitaktischer Abscheidung eine Schichtdicke d = 3 µm auf jeweils eine Halbleiterscheibe abgeschieden, so können in einem Ätzzyklus 20 Wafer epitaxiert werden, bevor mit der nächsten Kammerätze ein weiterer Ätzzyklus beginnt.

Während eines Ätzzyklus fällt der ZDD-Wert der epitaktisch aufgebrachten Schicht von Halbleiterscheibe zu Halbleiterscheibe kontinuierlich ab, d.h. jede nachfolgende Scheibe in einem Ätzzyklus hat eine andere Krümmung des vorderseitigen Randbereichs. Der Trend zur Verringerung des ZDD-Wertes ist unabhängig von der abgeschiedenen Schichtdicke d; die numerische Abnahme des ZDD-Wertes von Scheibe zu Scheibe hängt allerdings von der epitaktisch abgeschiedenen Schichtdicke d ab, wobei die Verringerung des ZDD-Wertes von Wafer zu Wafer innerhalb eines Ätzzyklus mit zunehmender Schichtdicke d ebenfalls größer wird.

Werden in einem Ätzzyklus beispielsweise 20 Halbleiterscheiben epitaktisch mit einer Schichtdicke von beispielsweise d = 2,75 µm beschichtet und hat der erste Wafer nach der Kammerätze hat einen ZDD von -5nm, dann hat der letzte Wafer in diesem Ätzzyklus bzw. vor der nächsten Kammerätze - ohne Anwendung des erfindungsgemäßen Verfahrens - bei einem ZDD-Abfall von 1nm von Wafer zu Wafer, einen ZDD von -25nm.

Mit dem erfindungsgemäßen Verfahren wird die ZDD-Variation - gemessen nach der SEMI M49-Methode bei 2 mm Randausschluss - der Vorderseite der Halbleiterscheiben so stark reduziert, dass innerhalb eines Ätzzyklus nur noch eine geringfügige Variation des ZDD auftritt. Während bei einem Standard-Prozess (Kammerätze, Ätzvorgang der Halbleiterscheibe, epitaktische Beschichtung) gemäß dem Stand der Technik die ZDD-Variation (gemessen bei 2 mm Randausschluss nach der SEMI M49 Methode) unter ansonsten gleichen Bedingungen durchschnittlich 18 nm beträgt, wird die ZDD-Variation bei einem Ätzzyklus mit 25 Halbleiterscheiben auf durchschnittlich ≤ 2 nm verringert.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispiels in der Zeichnung schematisch dargestellt und wird im Folgenden unter Bezugnahme auf die Zeichnung beschrieben.

### Figurenbeschreibung

- Figur 1: zeigt schematisch einen Epitaxie-Reaktor, mit dem ein erfindungsgemäßes Verfahren durchgeführt werden kann.
- Figur 2: zeigt schematisch einen Ausschnitt einer beschichteten Halbleiterscheibe auf einem Suszeptor eines Epitaxie-Reaktors.
- Figur 3: zeigt in einem Diagramm die Differenz Δ1 des Randabfalls vor und nach dem jeweiligen Beschichtungsvorgang für eine Serie von Halbleiterscheiben aus Silizium, die nicht nach einem erfindungsgemäßen Verfahren beschichtet wurden, im Vergleich zu solchen, die nach einem erfindungsgemäßen Verfahren in einer bevorzugten Ausführungsform beschichtet wurden.
- Figur 4: zeigt schematisch einen Ausschnitt einer beschichteten Halbleiterscheibe auf einem Suszeptor eines Epitaxie-Reaktors mit Querschnitten in zwei verschiedenen Winkeln.
- Figur 5: zeigt in einem Diagramm die Differenz Δ2 zwischen den 90°-Richtungen ( ) und den dazwischen liegenden Richtungen, insbesondere den 45°-Richtungen () für eine Serie von Halbleiterscheiben aus Silizium, die nach erfindungsgemäßen Verfahren in zwei verschiedenen bevorzugten Ausführungsformen beschichtetet wurden.
- Figur 6: zeigt schematisch einen Ausschnitt einer Oberfläche einer Halbleiterscheibe im Randbereich.

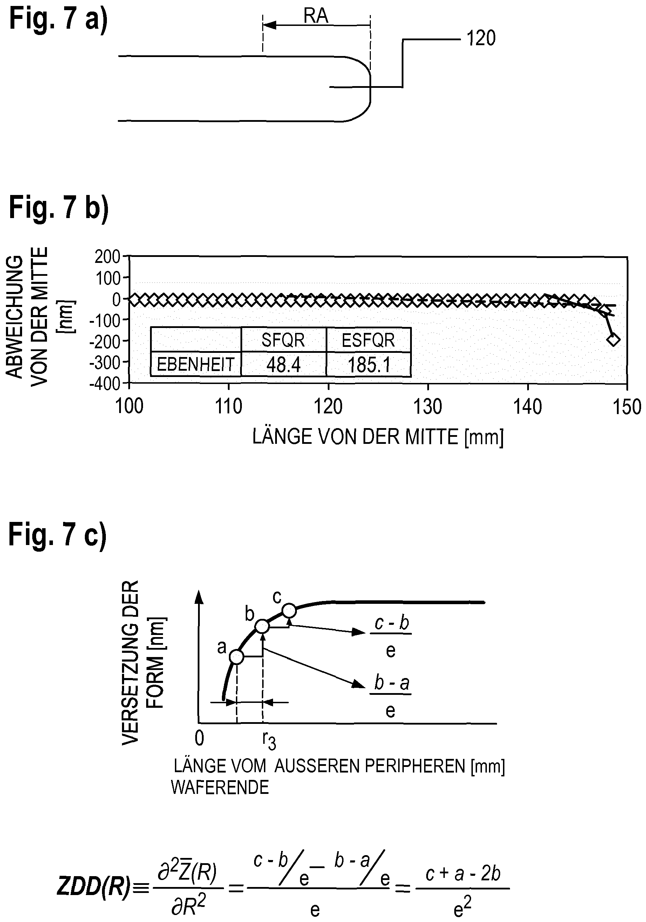

- Figur 7: zeigt schematisch die Festlegung des Randausschlusses RA (a)), die Bestimmung des SFQR und des ESFQR-Wertes (b)) sowie des ZDD-Wertes (c)).

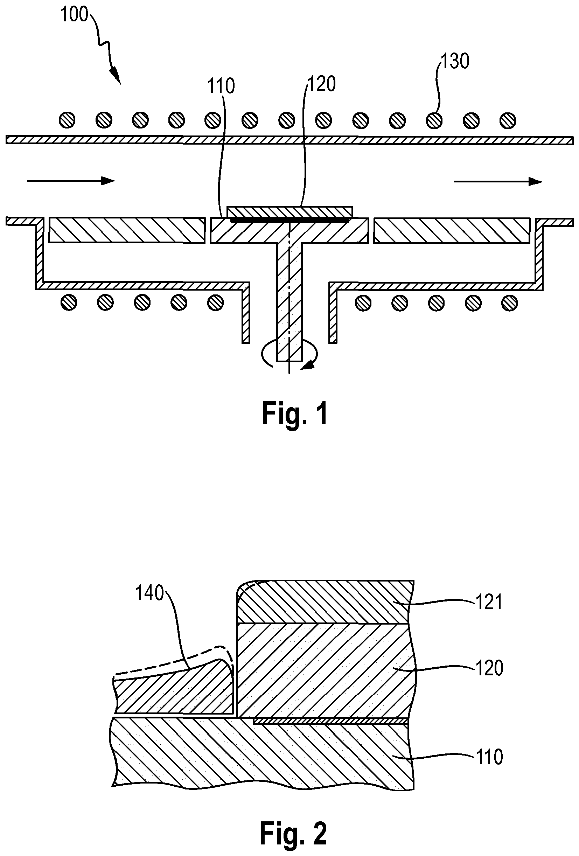

In Figur 1 ist beispielhaft und schematisch ein Epitaxie-Reaktor 100 im Querschnitt gezeigt, mit welchem bspw. ein erfindungsgemäßes Verfahren durchgeführt werden kann. In der Mitte des Epitaxie-Reaktors 100 befindet sich ein Suszeptor 110, auf welchem eine zu beschichtende Halbleiterscheibe 120, bspw. eine Siliziumscheibe (Siliziumwafer), angeordnet, d.h. abgelegt werden kann. Eine Halbleiterscheibe kann dabei, je nach Größe des Epitaxie-Reaktors bspw. einen Durchmesser von bis zu 450 mm aufweisen. Der Suszeptor 110 weist dabei eine mittige Vertiefung auf, sodass die Halbleiterscheibe 120 bspw. nur im Bereich weniger Millimeter ihres Randes auf dem Suszeptor 110 aufliegt.

Durch den Epitaxie-Reaktor 100 kann Gas geleitet werden, im vorliegenden Beispiel von einer Öffnung auf der linken Seite bis zu einer Öffnung auf der rechten Seite des Epitaxie-Reaktors 100, wie dies durch zwei Pfeile angedeutet ist. Mittels Wärmeerzeugungsmittel, bspw. Heizlampen 130 auf der oberen und der unteren Seite des Epitaxie-Reaktors 100, von denen beispielhaft eine mit einem Bezugszeichen versehen ist, können das durch den Epitaxie-Reaktor 100 geleitete Gas und die Halbleiterscheibe je nach Bedarf auf eine gewünschte Temperatur gebracht werden.

Zum Beschichten einer Halbleiterscheibe 120 wird nun ein erstes Abscheidegas, bspw. Trichlorsilan, ggf. gemischt mit Wasserstoff, durch den Epitaxie-Reaktor 100 geleitet. Gasfluss, Zeitdauer des Durchleitens sowie Temperatur können hierbei bspw. je nach gewünschter Dicke der epitaktisch abzuscheidenden Schicht auf der Halbleiterscheibe 120 eingestellt werden. Vorteilhafterweise wird bei einem Beschichtungsvorgang jeweils eine Schicht zwischen 1 und 10 µm, insbesondere zwischen 2 und 5µm auf der wenigstens einen Halbleiterscheibe abgeschieden.

Eine oftmals gewünschte Dicke der epitaktischen Schicht beträgt bspw. 4 µm. Typischerweise wird für eine derartige Schicht ein Gasfluss an Trichlorsilan von etwa 15 slm über eine Zeitdauer von etwa 100 s benötigt. Zudem kann der Suszeptor 110 mit der darauf angeordneten Halbleiterscheibe 120 mit einer vorgebbaren Rotationsgeschwindigkeit um eine Achse rotiert werden, wie dies in der Figur angedeutet ist. Auf diese Weise kann ein gleichmäßiges Abscheiden der epitaktischen Schicht auf der Halbleiterscheibe 120 erreicht werden. Während des Beschichtungsvorgangs scheidet sich jedoch auch im gesamten Epitaxie-Reaktor und insbesondere im Bereich um die Halbleiterscheibe 120 auf dem Suszeptor 110 unerwünschtes Material ab.

Zum Reinigen des Epitaxie-Reaktors 100, d.h. zum Entfernen oder zumindest Reduzieren des unerwünschten Materials, wird daher nach einer bestimmten Anzahl von Beschichtungsvorgängen ein Reinigungsvorgang, die Kammerätze, durchgeführt, bei dem zunächst ein zweites Ätzgas, bspw. Chlorwasserstoff, durch den Epitaxie-Reaktor 100 geleitet wird. Auf diese Weise kann das unerwünschte Material im Inneren des Epitaxie-Reaktors 100 entfernt bzw. zumindest reduziert werden.

Bevorzugt wird nach 8 bis 30, insbesondere jeweils nach 15 bis 20 Beschichtungsvorgängen der Reinigungsvorgang (Kammerätze) durchgeführt. Je nach verwendetem Epitaxie-Reaktor kann die Häufigkeit der Reinigungsvorgänge gewählt werden, um über alle Beschichtungsvorgänge hinweg eine optimale epitaktische Abscheidung zu ermöglichen.

Während des Reinigungsvorgangs befindet sich keine Halbleiterscheibe im Epitaxie-Reaktor.

Anschließend kann im Rahmen des Reinigungsvorgangs noch ein zweites Abscheidegas, bspw. Trichlorsilan, durch den Epitaxie-Reaktor 100 geleitet, um eine definierte Schicht Material, bspw. Silizium, im Inneren des Epitaxie-Reaktors 100 abzuscheiden. Diese Schicht dient der Versiegelung, um zu verhindern, dass ggf. aus den Oberflächen im Inneren des Epitaxie-Reaktors 100 diffundierende Verunreinigungen in die epitaktische Schicht auf der nachfolgend zu beschichtenden Halbleiterscheibe gelangen.

In Figur 2 ist schematisch ein Ausschnitt einer Halbleiterscheibe 120 auf dem Suszeptor 110 des Epitaxie-Reaktors 100 gezeigt. Auf der Halbleiterscheibe 120 befindet sich eine epitaktisch abgeschiedene Schicht 121. Hierbei sei angemerkt, dass die Verhältnisse der hier gezeigten Abmessungen zueinander nicht maßstabsgetreu sind.

Dabei ist zu sehen, dass die epitaktische Schicht 121 am Rand (in der Figur links) in ihrer Stärke abnimmt. Der Grund hierfür liegt in den Strömungsverhältnissen des Abscheidegases beim Beschichten der Halbleiterscheibe, die am Rand der Halbleiterscheibe anders sind als bspw. über deren Oberfläche. Weiterhin ist im Bereich um die Auflagefläche der Halbleiterscheibe 120 auf dem Suszeptor 110 unerwünschtes Material 140 vorhanden. Wie bereits erläutert, wird dieses Material 140 während der Beschichtungsvorgänge abgeschieden.

Während nun jedoch für jeden Beschichtungsvorgang eine neue Halbleiterscheibe 120 auf dem Suszeptor 110 angeordnet wird, nimmt die Stärke des abgeschiedenen Materials 140 auf den nicht von der Halbleiterscheibe bedeckten Bereichen des Suszeptors mit jedem Beschichtungsvorgang zu. Diese Zunahme des Materials 140 ist in der Figur 2 durch eine gestrichelte Linie dargestellt. Das auf dem Suszeptor abgeschiedene Material 140 führt für jeden Beschichtungsvorgang zu einem veränderten Temperaturfeld gegenüber dem vorausgegangenen Beschichtungsvorgang, da durch das abgeschiedene Material 140 die Wärmestrahlung des Suszeptors 110 verringert wird. Dies hat zur Folge, dass die Temperatur des Suszeptors 110 am Auflagepunkt der Halbleiterscheibe 120 mit zunehmender Zahl der Abscheidevorgänge sinkt und es zu einem zunehmenden Randabfall der epitaktischen Schicht 121 im Randbereich der Halbleiterscheibe 120, wie dies durch eine gestrichelte Linie in Figur 2 dargestellt ist, kommt. Darüber hinaus beeinflussen die Abscheidungen 120 auf dem Suszeptor 110 auch die Strömungsverhältnissen des Abscheidegases.

In einer bevorzugten Ausführungsform eines erfindungsgemäßen Verfahrens wird nun bspw. vor jedem Beschichtungsvorgang in einem Ätzvorgang ein erstes Ätzgas, bspw. Chlorwasserstoff, zusammen mit einem Trägergas, bspw. Wasserstoff, durch den Epitaxie-Reaktor 100 geleitet, so dass die Halbleiterscheibe vor dem Beschichtungsvorgang gezielt vorbehandelt wird.

Vorteilhafterweise wird der Gasfluss des ersten Ätzgases auf einen Wert zwischen 2 slm und 5 slm, der Gasfluss des zusätzlich zu dem ersten Ätzgas im Ätzvorgang verwendeten Trägergases auf einen Wert zwischen 30 slm und 110 slm, insbesondere zwischen 40 slm und 70 slm, und/oder die Temperatur im Epitaxie-Reaktor während des Ätzvorgangs auf einen Wert zwischen 1050°C und 1200°C eingestellt. Während des Ätzvorgangs wird die auf dem Suszeptor positionierte Halbleiterscheibe rotiert, um eine gleichmäßige Kontaktzeit zwischen Ätzgas und Scheibenoberfläche zu gewährleisten. Bevorzugt liegt die Rotationsgeschwindigkeit zwischen 20 und 60 Umdrehungen pro Minute (rpm), besonders bevorzugt zwischen 30 und 50 rpm.

Insbesondere sind ein Gasfluss des Ätzgases von 4 slm und ein Gasfluss des Trägergases von 50 slm bevorzugt, um eine besonders ebene Oberfläche zu erreichen. Hierzu ist dann bspw. eine Änderung nur der Dauer des Ätzvorgangs ausreichend. Durch diese Gasflüsse kann bspw. erreicht werden, dass ein Abtrag in der Mitte der Halbleiterscheibe höher ist als am Rand. Damit kann kompensiert werden, dass bei unerwünschtem Material im Bereich um die Halbleiterscheibe sich am Rand der Halbleiterscheibe beim Beschichtungsvorgang weniger Material abscheidet. Im Vergleich dazu führt ein herkömmlich verwendeter Gasfluss des Ätzgases von zwischen 0,9 slm und 1,5 slm bei einem Gasfluss des Trägergases von 50 slm oder geringer zu einem stärkeren Abtrag am Rand der Halbleiterscheibe bzw. zu einem homogen Ätzabtrag über die Scheibe.

Es ist von Vorteil, wenn bei dem ersten Ätzvorgang nach einer Kammerätze, die Dauer des dem Beschichtungsvorganges vorgelagerten Ätzvorgangs auf einen Wert zwischen 1 s und 10 s eingestellt wird. Bspw. kann der erste Ätzvorgang auf einen Wert von 3 s eingestellt werden. Mit jedem weiteren Ätzvorgang kann die Dauer dann bspw. um 1 bis 5 Sekunden erhöht werden. Damit kann reproduzierbar eine ebene Oberfläche der Halbleiterscheiben erreicht werden.

Weiterhin kann nun bspw. nach jedem Beschichtungsvorgang die Dauer des dem folgenden Beschichtungsvorgang vorausgehenden Ätzvorgangs erhöht werden. Bspw. kann die Dauer für den ersten Ätzvorgang nach einem Reinigungsvorgang auf 3 s eingestellt werden und für jeden folgenden Ätzvorgang kann die Dauer um jeweils 1 s erhöht werden. Auf diese Weise wird der Materialabtrag im mittleren Bereich (Zentrum) der Oberfläche der Halbleiterscheibe gegenüber dem Rand der Scheibe weiter erhöht. Damit kann der mit jedem weiteren Beschichtungsvorgang geringeren am Rand der Halbleiterscheibe abgeschiedenen Menge an Material entgegengewirkt werden, welcher Effekt durch die zunehmende Menge an Material 140 im Bereich um die Halbleiterscheibe 120 hervorgerufen wird.

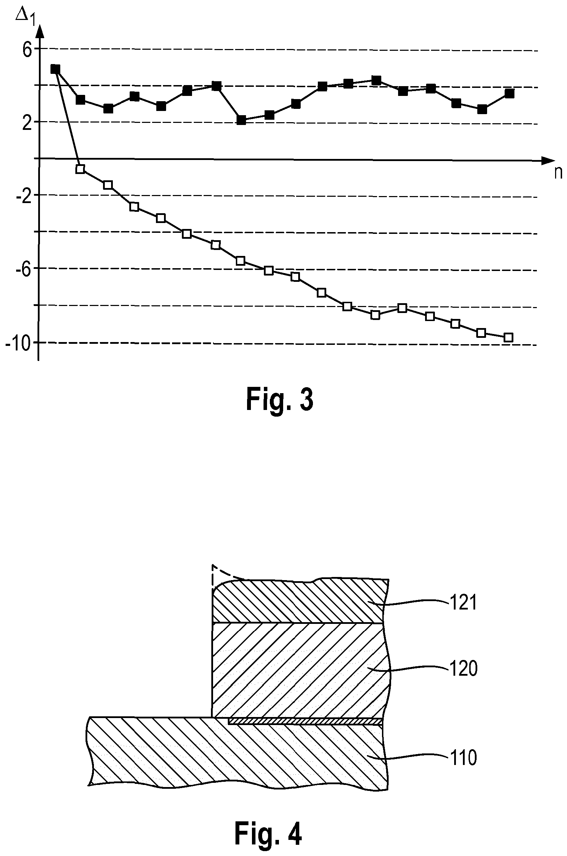

In Figur 3 ist für eine Serie von n aufeinander folgenden Beschichtungsvorgängen in einem Diagramm die Differenz des Randabfalls Δ1 in nm/mm2 (ausgedrückt in Form der Differenz des sog. ZDD, einer die Krümmung des Randbereichs beschreibenden Messgröße) von dabei beschichteten Halbleiterscheiben über der Anzahl der Beschichtungsvorgänge n aufgetragen.

Mit leeren Rauten sind dabei Werte für Beschichtungsvorgänge, die nicht nach einem erfindungsgemäßen Verfahren beschichtet wurden, und mit ausgefüllten Rauten sind Werte für Beschichtungsvorgänge, die nach einem erfindungsgemäßen Verfahren in einer bevorzugten Ausführungsform beschichtet wurden, d.h. mit jeweils individuell eingestellten Ätzparametern in einem vorausgehenden Ätzvorgang, dargestellt. Bei den hier gezeigten Werten nach dem erfindungsgemäßen Verfahren wurden beispielhaft ein Gasfluss des ersten Ätzgases auf 4 slm und der Gasfluss des Trägergases auf 50 slm eingestellt. Der erste Ätzvorgang wurde beispielhaft mit einer Dauer von 3 s vorgenommen und jeder folgende Ätzvorgang mit einer um jeweils 1 s erhöhten Dauer.

Dabei ist zu sehen, dass der Randabfall vom ersten Beschichtungsvorgang nach einem Reinigungsvorgang (in der Figur links) über die Beschichtungsvorgänge hinweg (in der Figur nach rechts) bei einem herkömmlichen Verfahren (leere Rauten) abnimmt und somit eine deutliche Variation aufweist.

Für die Werte bei dem erfindungsgemäßen Verfahren (ausgefüllte Rauten) hingegen ist zu sehen, dass der Randabfall vom ersten Beschichtungsvorgang nach einem Reinigungsvorgang (in der Figur links) über die Beschichtungsvorgänge hinweg (in der Figur nach rechts) relativ konstant ist und somit eine deutlich geringere Variation aufweist, als dies ohne die Veränderung der Dauer des Ätzvorgangs oder ohne Ätzvorgang der Fall wäre.

In Figur 4 ist schematisch ein Ausschnitt einer Halbleiterscheibe 120 auf dem Suszeptor 110 des Epitaxie-Reaktors 100 gezeigt, ähnlich zu Figur 2. Auf der Halbleiterscheibe 120 befindet sich eine epitaktisch abgeschiedene Schicht 121. Hierzu sei angemerkt, dass die Verhältnisse der hier gezeigten Abmessungen zueinander nicht maßstabsgetreu sind.

Hierbei sind zwei verschiedene Querschnittsansichten der Halbleiterscheibe gezeigt. Mit der gestrichelten Linie am linken oberen Rand ist ein Querschnitt durch eine der vier 90°-Richtungen () eines (100)-Kristalls (d.h. der Halbleiterscheibe) gezeigt, welche in der Regel bei den Winkeln 0°, 90°, 180° und 270°, jeweils bezogen auf die Kristallorientierung der Halbleiterscheibe, beispielsweise dem Notch, auftreten. Bei diesen Stellen bzw. in diesen Richtungen wächst die epitaktisch abgeschiedene Schicht aufgrund der Kristallorientierung stärker als in den übrigen Bereichen.

Mit der durchgezogenen Linie am linken oberen Rand ist ein Querschnitt gezeigt, der zwischen zwei 90°-Richtungen, insbesondere den 45°-Richtungen liegt. Die Bereiche zwischen den 90°-Richtungen machen dabei den größten Teil der Halbleiterscheibe aus. Dort tritt in der Regel ein starker Randabfall auf, wie dies auch in Figur 2 gezeigt ist.

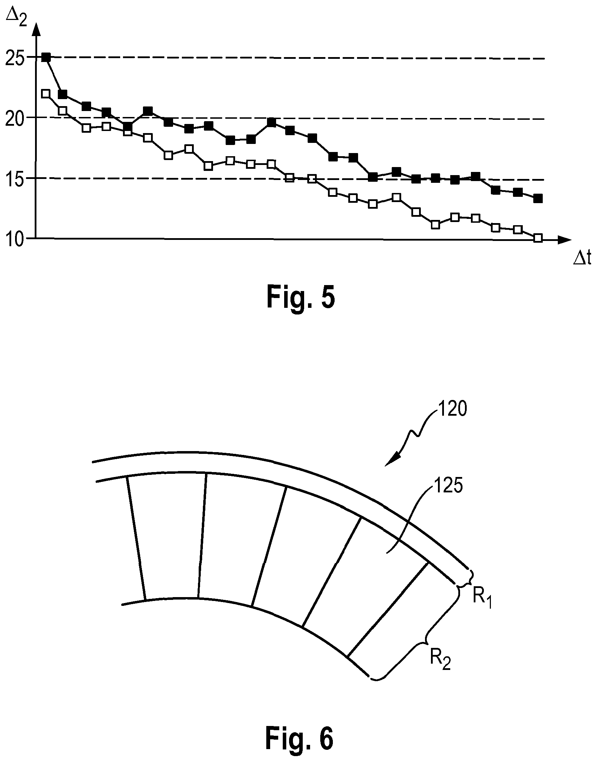

In Figur 5 ist für eine Serie von aufeinander folgenden Beschichtungsvorgängen in einem Diagramm die Differenz des Randabfalls Δ2 in nm/mm2 (ausgedrückt in Form der Differenz des sog. ZDD, einer die Krümmung des Randbereichs beschreibenden Messgröße) zwischen 90°- und 45°-Richtungen (wie sie in Figur 4 veranschaulicht sind) von dabei beschichteten Halbleiterscheiben über der Dauer Δt der jeweiligen Ätzvorgänge vor dem jeweiligen Beschichtungsvorgang aufgetragen. Die gezeigten Werte entsprechen zwei verschiedenen bevorzugten erfindungsgemäßen Ausführungsformen.

Mit ausgefüllten Rauten sind dabei Werte für Beschichtungsvorgänge, bei deren vorhergehenden Ätzvorgängen ein Gasfluss des ersten Ätzgases auf 5 slm und der Gasfluss des Trägergases auf 50 slm eingestellt wurden und mit leeren Rauten sind Werte für Beschichtungsvorgänge, bei deren vorhergehenden Ätzvorgängen ein Gasfluss des ersten Ätzgases auf 4 slm und der Gasfluss des Trägergases auf 50 slm eingestellt wurden, gezeigt. Der erste Ätzvorgang wurde bei beiden Verfahren mit einer Dauer Δt von 3 s vorgenommen und jeder folgende Ätzvorgang mit einer um jeweils 1 s erhöhten Dauer Δt.

Dabei ist zu sehen, dass die Differenz des Randabfalls Δ2 zwischen 90°- und 45°-Richtungen zum einen mit zunehmender Dauer Δt des Ätzvorgangs geringer wird und zum anderen mit einem Gasfluss des ersten Ätzgases von 4 slm geringer ist als mit einem Gasfluss von 5 slm. Dies zeigt, dass durch eine geeignete Einstellung des Gasflusses des ersten Ätzgases und/oder der Dauer des Ätzvorgangs eine sehr geringe Differenz des Randabfalls Δ2 zwischen 90°- und 45°-Richtungen erreicht werden kann, was wiederum zu einer sehr glatten Oberfläche der Halbleiterscheibe führt. Die Differenz des Randabfalls Δ2 zwischen 90°- und 45°-Richtungen beschreibt die Anisotropie der 4-fach Rotationssymmetrie mit Blick auf die (100) Ebene für Parameter wie ZDD, SFQR, ESFQR, ROA, kurz 4-fach Symmetrie; Δ2 wird typischerweise maximal für ZDD Werten bei 90° und 45°.

Da durch das erfindungsgemäße Verfahren gezielt am Rand weniger stark geätzt werden kann als in der Scheibenmitte sowie die sogenannte 4-fach Symmetrie deutlich reduziert wird, weisen die mit dem erfindungsgemäßen Verfahren hergestellten epitaktisch beschichteten Halbleiterscheiben sehr gute Geometriewerte für die Vorderseite, insbesondere im Randbereich, auf.

In Figur 6 ist schematisch ein Ausschnitt einer Oberfläche einer Halbleiterscheibe 120 im Randbereich gezeigt. Anhand dieser Figur soll kurz der sog. ESFQR-Wert einer solchen Halbleiterscheibe erläutert werden.

Wie eingangs bereits erwähnt, steht ESFQR dabei für "Edge Site Frontsurfacereferenced least sQuares/Range" und dessen Wert gibt die Flachheit der Halbleiterscheibe an. Insbesondere werden damit positive und negative Abweichungen einer Oberfläche von einer ebenen Referenzfläche zusammengefasst.

Der ESFQR-Wert wird dabei in der Regel für einen Randbereich einer Halbleiterscheibe, wie dieser in Figur 6 ausschnittsweise zu sehen ist, angegeben. Dabei bleibt ein Randausschluss R1 vom äußeren Rand der Halbleiterscheibe bei der Ermittlung des ESFQR-Wertes unberücksichtigt. Weiterhin wird der ESFQR-Wert über eine bestimmte Anzahl an Sektoren 125, die in der Regel ringförmig am Rand (ohne den Randausschluss) der Halbleiterscheibe aneinandergereiht sind, ermittelt. Dabei wird eine bestimmte Länge R2 der Sektoren in radialer Richtung verwendet.

Eine epitaktisch beschichtete Halbleiterscheibe, insbesondere eine Siliziumscheibe, weist - gemessen nach der SEMI M49-Methode - einen maximalen ESFQR-Wert von weniger als 9 nm auf bei einem Randausschluss von wenigstens 2 mm und wenigstens 50 Sektoren mit jeweils einer Länge von höchstens 40 mm auf.

Der maximale ESFQR-Wert von weniger als 9 nm einer erfindungsgemäß epitaktisch beschichteten Halbleiterscheibe ist primär die Folge der durch das erfindungsgemäße Verfahren reduzierten 4-fach-Symmetrie der Vorderseite der Scheibe aus Halbleitermaterial vor der epitaktischen Beschichtung. Durch das erfindungsgemäße Verfahren wird an den 90°-Richtungen am Rand der Scheibe mehr geätzt als an Richtungen zwischen zwei 90°-Richtungen, insbesondere den 45°-Richtungen, wodurch an den 90°-Richtungen der Scheibe eine Vertiefung im Vergleich zu den Richtungen zwischen zwei 90°-Richtungen geätzt wird. Zusätzlich erfolgt mit dem erfindungsgemäßen Verfahren ein höherer Ätzabtrag im Zentrum der Scheibe im Vergleich zum Randbereich.

Die Vertiefungen an den 90°-Richtungen und der höhere Ätzabtrag im Zentrum der Scheibe ermöglichen die deutlich verringerte 4-fach-Symmetrie der epitaktisch beschichteten Scheibe gegenüber einer Scheibe, die nach dem Stand der Technik vor der Epitaxie geätzt wurde.

Die Tabelle 1 zeigt die Verringerung der 4-fach-Symmetrie einer mit dem erfindungsgemäßen Verfahren hergestellten epitaktisch beschichteten Siliciumscheibe. Die 4-fach-Symmetrie ist dabei als Differenz der ZDD-Werte an den 90°-Richtungen und den ZDD-Werten an den Richtungen zwischen zwei 90°-Richtungen, insbesondere den 45°-Richtungen angegeben. Der Randausschluss beträgt jeweils 2 mm und die Dicke der epitaktisch abgeschiedenen Schicht 3 µm.

**Tabelle 1: Beispiel für die Beeinflussung der Differenz (4-fach Symmetrie) zwischen 90°- und 45°-Richtungen, ausgedrückt als ZDD bei 2 mm Randausschluss, durch das erfindungsgemäße Verfahren, Dicke der epitaktisch abgeschiedenen Schicht: 3 µm**

| Ätzbedingungen | | | | ZDD, 2 mm Randausschluss, nm |
|---|---|---|---|---|
| HCl-Fluss, slm | H₂-Fluss, slm | Temperatur, °C | Ätzdauer, s | |
| Standard | | | | |
| 0,9 | 50 | 1130 | 30 | 21 |

| Erfindungsgemäßes Verfahren | | | | |
|---|---|---|---|---|
| 4 | 50 | 1130 | 10 | 18 |
| 4 | 50 | 1130 | 19 | 17 |
| 4 | 50 | 1115 | 19 | 14 |
| 4 | 50 | 1110 | 19 | 13 |
| 4 | 50 | 1110 | 23 | 10 |
| 4 | 50 | 1110 | 30 | 8 |
| 4 | 50 | 1100 | 60 | 3 |
| 4 | 50 | 1090 | 80 | -2 |

Im letzten Beispiel in Tabelle 1 ist eine mit dem erfindungsgemäßen Verfahren hergestellte Halbleiterscheibe mit einer negativen 4-fach-Symmetrie hergestellt worden. Bei einer negativen 4-fach-Symmetrie liegen die ZDD Werte der 90°-Richtungen niedriger als die der 45°-Richtungen, so dass der resultierende ZDD-Wert negativ ist.

Eine epitaktisch beschichtete Halbleiterscheibe kann bspw. durch ein erfindungsgemäßes Verfahren hergestellt werden. Durch den niedrigen maximalen ESFQR-Wert von weniger als 9 nm ist die Halbleiterscheibe besonders gut für die Verwendung in der Halbleiterindustrie, insbesondere zur Fabrikation von hochintegrierten elektronischen Bauelementen wie bspw. Mikroprozessoren oder Speicherchips geeignet, da für die moderne Mikroelektronik Ausgangsmaterialien mit hohen Anforderungen an bspw. Ebenheit, Randgeometrie und Dickenverteilung, benötigt werden.

## Patentansprüche

1. Verfahren zum Beschichten von Halbleiterscheiben (120) mit jeweils einer epitaktisch abgeschiedenen Schicht (121) in einem Epitaxie-Reaktor (100),
wobei in einem Beschichtungsvorgang wenigstens eine Halbleiterscheibe (120) auf einem jeweiligen Suszeptor (110) in dem Epitaxie-Reaktor (100) angeordnet wird und ein erstes Abscheidegas zum Beschichten der wenigstens einen Halbleiterscheibe (120) durch den Epitaxie-Reaktor (100) geleitet wird, wobei vor einem Beschichtungsvorgang jeweils ein Ätzvorgang durchgeführt wird, bei dem ein erstes Ätzgas und ein Trägergas durch den Epitaxie-Reaktor (100) geleitet werden, und wobei jeweils nach einer vorgebbaren Anzahl an Beschichtungsvorgängen ein Reinigungsvorgang durchgeführt wird, bei dem ein zweites Ätzgas und anschließend insbesondere ein zweites Abscheidegas durch den Epitaxie-Reaktor (100) geleitet werden, **dadurch gekennzeichnet, dass** für zwei oder mehr dem jeweiligen Beschichtungsvorgang vorausgehende Ätzvorgänge wenigstens eine den Ätzvorgang beeinflussende Größe individuell auf den betreffenden Ätzvorgang eingestellt wird,
wobei zwischen zwei aufeinanderfolgenden Reinigungsvorgängen jeweils nach ein oder mehreren Beschichtungsvorgängen die wenigstens eine den Ätzvorgang beeinflussende Größe gegenüber einem vorausgehenden Ätzvorgang verändert wird,
wobei die wenigstens eine den Ätzvorgang beeinflussende Größe eine Temperatur im Epitaxie-Reaktor (100) während des Ätzvorgangs umfasst und die Temperatur im Epitaxie Reaktor (100) gegenüber einem vorausgehenden Ätzvorgang erniedrigt wird.

2. Verfahren nach Anspruch 1, wobei die wenigstens eine den Ätzvorgang beeinflussende Größe unter Berücksichtigung von geometrischen Abmessungen der nächsten zu beschichtenden Halbleiterscheibe (120) individuell auf den betreffenden Ätzvorgang eingestellt wird.

3. Verfahren nach einem der vorstehenden Ansprüche, wobei die wenigstens eine den Ätzvorgang beeinflussende Größe einen Gasfluss des ersten Ätzgases, einen Gasfluss des Trägergases, eine Dauer des Ätzvorgangs und/oder eine Rotationsgeschwindigkeit der Halbleiterscheibe umfasst.

4. Verfahren nach Anspruch 3, wobei der Gasfluss des ersten Ätzgases auf einen Wert zwischen 2 slm und 5 slm, der Gasfluss des zusätzlich zu dem ersten Ätzgas im Ätzvorgang verwendeten Gases auf einen Wert zwischen 30 slm und 110 slm, insbesondere zwischen 40 slm und 70 slm und/oder die Temperatur im Epitaxie-Reaktor (100) während des Ätzvorgangs auf einen Wert zwischen 1050°C und 1200°C eingestellt wird.

5. Verfahren nach Anspruch 4, wobei bei dem ersten Ätzvorgang nach einem Reinigungsvorgang die Dauer des Ätzvorgangs auf einen Wert zwischen 1 s und 10 s eingestellt wird.

6. Verfahren nach einem der vorstehenden Ansprüche, wobei weiterhin jeweils vor einem Ätzvorgang für eine Vorbehandlung Wasserstoff durch den Epitaxie-Reaktor (100) geleitet wird.

7. Verfahren nach einem der vorstehenden Ansprüche, wobei jeweils nach 8 bis 30, insbesondere jeweils nach 15 bis 20 Beschichtungsvorgängen der Reinigungsvorgang durchgeführt wird.

8. Verfahren nach einem der vorstehenden Ansprüche, wobei als erstes Ätzgas und/oder als zweites Ätzgas Chlorwasserstoff verwendet wird.

9. Verfahren nach einem der vorstehenden Ansprüche, wobei bei einem Beschichtungsvorgang jeweils eine Schicht (121) zwischen 1 und 10 µm, insbesondere zwischen 2 und 5µm auf der wenigstens einen Halbleiterscheibe (120) abgeschieden wird.

10. Verfahren nach einem der vorstehenden Ansprüche, wobei als Halbleiterscheiben (120) Siliziumscheiben verwendet werden.

11. Verfahren nach einem der vorstehenden Ansprüche, wobei als Trägergas Wasserstoff verwendet wird.

12. Verfahren nach einem der vorstehenden Ansprüche, wobei als erstes Abscheidegas und/oder als zweites Abscheidegas Trichlorsilan verwendet wird.

## Claims

1. Method for coating semiconductor wafers (120) with an epitaxially deposited layer (121) in an epitaxy reactor (100), wherein in a coating method at least one semiconductor wafer (120) is arranged on a respective susceptor (110) in the epitaxy reactor (100) and a first deposition gas for coating the at least one semiconductor wafer (120) is passed through the epitaxy reactor (100), wherein prior to a coating method an etching method in which a first etching gas and a carrier gas are passed through the epitaxy reactor (100) is carried out in each case, and wherein a cleaning method is carried out in each case after a predeterminable number of coating methodes, in which a second etching gas and subsequently in particular a second deposition gas are passed through the epitaxy reactor (100), **characterized in that** for two or more etching methodes preceding the respective coating method at least one variable influencing the etching method is individually adjusted to the respective etching method and the temperature in the epitaxy reactor (100) is lowered compared to a preceding etching method, wherein between two successive cleaning methodes, in each case after one or more coating methodes, the at least one variable influencing the etching method is changed in comparison with a preceding etching method.

2. Method according to claim 1, wherein the at least one variable influencing the etching method is individually adjusted to the relevant etching method, taking into account geometrical dimensions of the next semiconductor wafer (120) to be coated.

3. Method according to one of the above claims, wherein the at least one variable influencing the etching method comprises a gas flow of the first etching gas, a gas flow of the carrier gas, a temperature in the epitaxy reactor (100) during the etching method, a duration of the etching method and/or a rotation speed of the semiconductor wafer.

4. Method according to claim 3, wherein the gas flow of the first etching gas is adjusted to a value between 2 slm and 5 slm, the gas flow of the gas used in addition to the first etching gas in the etching method is adjusted to a value between 30 slm and 110 slm, in particular between 40 slm and 70 slm, and/or the temperature in the epitaxy reactor (100) is adjusted to a value between 1050°C and 1200°C during the etching method.

5. Method according to claim 4, whereby in the first etching method after a cleaning methode the duration of the etching method is set to a value between 1 s and 10 s.

6. Method according to one of the above claims, whereby furthermore hydrogen is passed through the epitaxy reactor (100) before each etching method for a pretreatment.

7. Method according to one of the above claims, whereby the cleaning method is carried out after 8 to 30, in particular after 15 to 20 coating methods.

8. Method according to one of the above claims, whereby hydrogen chloride is used as the first etching gas and/or as the second etching gas.

9. Method according to one of the above claims, wherein during a coating method a layer (121) between 1 and 10 µm, in particular between 2 and 5 µm, is deposited on the at least one semiconductor wafer (120).

10. Method according to one of the above claims, whereby silicon wafers (120) are used as semiconductor wafers.

11. Method according to one of the above claims, using hydrogen as carrier gas.

12. Method according to one of the above claims, whereby trichlorosilane is used as the first separation gas and/or as the second separation gas.

## Revendications

1. Procédé de revêtement de plaquettes de semi-conducteurs (120) avec une couche déposée par épitaxie (121) dans un réacteur d'épitaxie (100), dans lequel, dans un processus de revêtement, au moins une plaquette semi-conductrice (120) est disposée sur un suscepteur respectif (110) dans le réacteur d'épitaxie (100) et un premier gaz de dépôt pour le revêtement de la au moins une plaquette semi-conductrice (120) est conduit à travers le réacteur d'épitaxie (100), dans lequel, avant un processus de revêtement, un processus de gravure est effectué, dans lequel un premier gaz de gravure et un gaz porteur sont conduits à travers le réacteur d'épitaxie (100), et dans lequel un processus de nettoyage est effectué après un nombre prédéterminable de processus de revêtement, dans lequel un deuxième gaz de gravure et ensuite en particulier un deuxième gaz de dépôt sont conduits à travers le réacteur d'épitaxie (100), **caractérisé en ce que** pour deux ou plusieurs processus de gravure précédant le processus de revêtement respectif, au moins une variable influençant le processus de gravure est adaptée individuellement au processus de gravure respectif et la température dans le réacteur d'épitaxie (100) est abaissée par rapport à un processus de gravure précédent, dans laquelle, entre deux processus de nettoyage successifs, dans chaque cas après un ou plusieurs processus de revêtement, la ou les variables influençant le processus de gravure sont modifiées par rapport à un processus de gravure précédent.

2. Procédé selon la revendication 1, dans lequel au moins une variable influençant le processus de gravure est adaptée individuellement au processus de gravure concerné, en tenant compte des dimensions géométriques de la prochaine plaquette semi-conductrice (120) à revêtir.

3. Procédé selon l'une des revendications ci-dessus, dans lequel la au moins une variable influençant le processus de gravure comprend un flux de gaz du premier gaz de gravure, un flux de gaz du gaz porteur, une température dans le réacteur d'épitaxie (100) pendant le processus de gravure, une durée du processus de gravure et/ou une vitesse de rotation de la plaquette semi-conductrice.

4. Procédé selon la revendication 3, dans lequel le débit de gaz du premier gaz de gravure est réglé à une valeur comprise entre 2 slm et 5 slm, le débit de gaz du gaz utilisé en plus du premier gaz de gravure dans le processus de gravure est réglé à une valeur comprise entre 30 slm et 110 slm, en particulier entre 40 slm et 70 slm et/ou la température dans le réacteur d'épitaxie (100) est réglée à une valeur comprise entre 1050°C et 1200°C pendant le processus de gravure.

5. Procédé selon la revendication 4, dans laquelle, dans le premier processus de gravure après un processus de nettoyage, la durée du processus de gravure est ajustée à une valeur comprise entre 1 s et 10 s.

6. Procédé selon l'une des revendications ci-dessus, dans lequel en outre, dans chaque cas avant un processus de gravure pour un prétraitement, de l'hydrogène est passé à travers le réacteur d'épitaxie (100).

7. Procédé selon l'une des revendications ci-dessus, dans lequel le nettoyage est effectué après 8 à 30, en particulier après 15 à 20 processus de revêtement.

8. Procédé selon l'une des revendications ci-dessus, utilisant le chlorure d'hydrogècomme premier gaz de gravure et/ou le chlorure d'hydrogène comme second gaz de gravure

9. Procédé selon l'une des revendications ci-dessus, dans laquelle, au cours d'un processus de revêtement, une couche (121) comprise entre 1 et 10 µm, en particulier entre 2 et 5 µm, est déposée sur la au moins une plaquette semi-conductrice (120).

10. Procédé selon l'une des revendications ci-dessus, dans laquelle des plaquettes de silicium (120) sont utilisées comme plaquettes de semi-conducteurs.

11. Procédé selon l'une des revendications ci-dessus, utilisant l'hydrogène comme gaz porteur.

12. Procédé selon l'une des revendications ci-dessus, dans lequel le trichlorosilane est utilisé comme premier gaz de séparation et/ou comme deuxième gaz de séparation.
